(19) Europäisches Patentamt
European Patent Office
Office européen des brevets

(11) **EP 4 156 557 A1**

(12) **EUROPEAN PATENT APPLICATION**
published in accordance with Art. 153(4) EPC

(43) Date of publication:
**29.03.2023  Bulletin 2023/13**

(21) Application number: **21829717.4**

(22) Date of filing: **22.06.2021**

(51) International Patent Classification (IPC):
**H04B 17/10** $^{(2015.01)}$

(52) Cooperative Patent Classification (CPC):
**G01R 27/06; H04B 17/10; H04W 24/08**

(86) International application number:
**PCT/CN2021/101469**

(87) International publication number:
**WO 2021/259239 (30.12.2021 Gazette 2021/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **22.06.2020   CN 202010575962**

(71) Applicant: **ZTE Corporation**
**Shenzhen, Guangdong 518057 (CN)**

(72) Inventors:
• **NIU, Kun**
  **Shenzhen, Guangdong 518057 (CN)**

• **ZHAO, Jitao**
  **Shenzhen, Guangdong 518057 (CN)**
• **LI, Yongzheng**
  **Shenzhen, Guangdong 518057 (CN)**
• **LI, Yanqing**
  **Shenzhen, Guangdong 518057 (CN)**
• **ZHANG, Hongxing**
  **Shenzhen, Guangdong 518057 (CN)**

(74) Representative: **Canzler & Bergmeier**
**Patentanwälte**
**Partnerschaft mbB**
**Despag-Straße 6**
**85055 Ingolstadt (DE)**

(54) **STANDING WAVE RATIO CALCULATION METHOD AND APPARATUS, NETWORK DEVICE AND STORAGE MEDIUM**

(57)     Provided are a standing wave ratio calculation method and apparatus, a network device and a storage medium. The method comprises: determining a time domain position of an SSB symbol according to cell configuration information; on the basis of the time domain position, collecting a feedback signal and a reflected signal which correspond to the SSB symbol; and calculating a corresponding standing wave ratio on the basis of the feedback signal and the reflected signal which correspond to the SSB symbol.

FIG. 1

**Description**

CROSS-REFERENCE TO RELATED APPLICATIONS

The present disclosure claims the priority to the Chinese Patent Application No. CN202010575962.5 entitled "STANDING WAVE RATIO CALCULATION METHOD AND APPARATUS, NETWORK DEVICE AND STORAGE MEDIUM" and filed on June 22, 2020, the entire contents of which are incorporated herein by reference.

TECHNICAL FIELD

Embodiments of the present disclosure relate to, but are not limited to, the field of communications, and particularly relate to, but are not limited to, a standing wave ratio calculation method and apparatus, a network device and a storage medium.

BACKGROUND

A standing wave ratio is an important indicator of an impedance matching state of a communication system, and has important guiding significance for detection of an antenna feeder system and field construction quality. In the related technology, a vector standing wave ratio calculation function is generally used for calculation of the standing wave ratio in real time and detection. A vector standing wave ratio function in a Remote Radio Unit (RRU) system needs to collect feedback signals and reflected signals in a time-division manner, and convert the feedback signals and the reflected signals into a frequency domain to calculate standing wave ratios at expected frequency points. However, the vector standing wave ratio calculation function in the related technology can be merely applied to 2G, 3G and 4G, but is not applicable to 5G New Radio (NR) signals, because it cannot be ensured that the collected signals are effective signals due to the characteristics of the signals of a 5G physical layer when the feedback signals and the reflected signals are collected in the time-division manner, and a failure to collect the signals may even occur.

SUMMARY

The embodiments of the present disclosure provide a standing wave ratio calculation method, including: determining a time domain position of a synchronization/broadcast block (Synchronization Signal/Physical Broadcast CHannel Block, SS/PBCH Block, SSB) symbol according to cell configuration information; collecting a feedback signal and a reflected signal, which correspond to the SSB symbol, based on the time domain position; and calculating a corresponding standing wave ratio based on the feedback signal and the reflected signal corresponding to the SSB symbol.

The embodiments of the present disclosure further provide a standing wave ratio calculation apparatus, including: a position determining module configured to determine a time domain position of an SSB symbol according to cell configuration information; a collection module configured to collect a feedback signal and a reflected signal, which correspond to the SSB symbol, based on the time domain position; and a calculation module configured to calculate a corresponding standing wave ratio based on the feedback signal and the reflected signal corresponding to the SSB symbol.

The embodiments of the present disclosure further provide a network device, including a processor and a memory, and the processor is configured to execute one or more computer programs stored in the memory, so as to perform the standing wave ratio calculation method according to the present disclosure.

The embodiments of the present disclosure further provide a computer-readable storage medium having one or more programs stored thereon. When the one or more programs are executed by one or more processors, the one or more processors are caused to perform the standing wave ratio calculation method according to the present disclosure.

BRIEF DESCRIPTION OF DRAWINGS

FIG. 1 is a flowchart illustrating a standing wave ratio calculation method according to the present disclosure;
FIG. 2 is a diagram illustrating characteristics of a 5G NR SSB symbol according to the present disclosure;
FIG. 3 is a detailed flowchart illustrating a standing wave ratio calculation method according to the present disclosure;
FIG. 4 is a schematic structural diagram of a standing wave ratio calculation apparatus according to the present disclosure; and
FIG. 5 is a schematic structural diagram of a network device according to the present disclosure.

DETAIL DESCRIPTION OF EMBODIMENTS

In order to make the objectives, technical solutions and advantages of the present disclosure clearer, the embodiments of the present disclosure are further described in detail below in conjunction with the specific implementations and accompanying drawings. It should be understood that the specific embodiments described herein are merely intended to explain the present disclosure, rather than limiting the present disclosure.

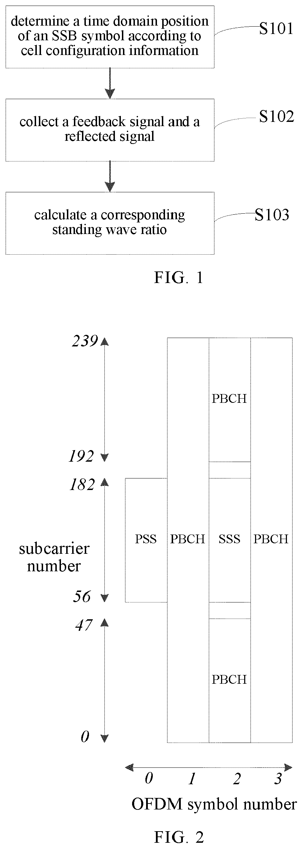

FIG. 1 is a flowchart illustrating a standing wave ratio calculation method according to the present disclosure.

The present disclosure provides a standing wave ratio calculation method, with reference to FIG. 1, including operations S101 to S103.

In operation S101, a time domain position of a synchronization/broadcast block (Synchronization Signal/Physical Broadcast CHannel Block, SS/PBCH Block, SSB) symbol is determined according to cell configuration information.

In operation S102, a feedback signal and a reflected signal, which correspond to the SSB symbol, are collected based on the time domain position.

In operation S103, a corresponding standing wave ratio is calculated based on the feedback signal and the reflected signal corresponding to the SSB symbol.

In the related technology, a vector standing wave ratio calculation function is used for realizing a calculation of a standing wave ratio and detection. In a RRU system, the vector standing wave ratio function needs to collect the feedback signals and the reflected signals in a time-division manner, and convert the collected signals into the frequency domain to calculate the standing wave ratios at the expected frequency points. Since the 5G NR adopts time-division collection and performs resource scheduling in the frequency domain in units of Resource Blocks (RBs), a corresponding standing wave ratio calculation solution needs to be designed for the 5G NR. In order to realize successful calculation of the standing wave ratio, when the feedback signals and the reflected signals collected in the time-division collection process are converted into the frequency domain, signals need to be capable of being collected at the corresponding frequency points in the frequency domain, so as to ensure correct calculation of the standing wave ratio.

FIG. 2 illustrates the characteristics to a 5G NR SSB symbol. With reference to FIG. 2, an SSB includes 4 Orthogonal Frequency Division Multiplexing (OFDM) symbols numbered from 0 to 3 in terms of time domain, and includes 240 consecutive subcarriers (20 RBs) numbered from 0 to 239 in terms of frequency domain. As can be seen from FIG. 2, a Primary Synchronization Signal (PSS) and a Secondary Synchronization Signal (SSS) are located on the symbol 0 and the symbol 2, the subcarriers numbered from 56 to 182 are 127 subcarriers in total in the frequency domain, and some subcarriers on each of two sides of the PSS/SSS serve as a guard band (set to 0) in the frequency domain. The low-end subcarriers numbered from 0 to 55 and the high-end subcarriers numbered from 183 to 239 of the PSS are set to 0 and serve as guard bands, and the low-end subcarriers numbered from 48 to 55 and the high-end subcarriers numbered from 183 to 191 of the SSS are set to 0 and serve as guard bands. Physical Broadcast Channels (PBCHs) are located on the symbols 1, 2 and 3, $240 * 0.75 = 180$ subcarriers are left after subtracting Demodulation Reference Signals (DMRSs) from the symbols 1 and 3, and $(240 - 127 - 8 - 9) * 0.75 = 72$ subcarriers are left after subtracting the DMRSs from the symbol 2. The DMRSs are inserted in the PBCHs at an interval of 4 subcarriers, and an initial offset position is $v = N_{ID}^{cell} \bmod 4$ , which represents that the value v is determined by a physical cell ID.

The time domain position of the SSB symbol may be determined according to the cell configuration information. The cell configuration information may include, but is not limited to, an Absolute Radio Frequency Channel Number (ARFCN), a Global Synchronization Channel Number (GSCN), an SSB time-domain transmission period, and a specific position of an SSB within one period. The operation of determining the time domain position of the SSB symbol according to the cell configuration information (i.e., the operation S101) may include: determining a cycle period of the SSB symbol; determining a transmission position case (CASE) of the SSB symbol within the cycle period; and determining the time domain position of the SSB symbol according to the transmission position case.

The SSB symbol is transmitted periodically, the cycle period may be determined according to an SSB time-domain transmission period parameter, and currently, configurable cycle periods include 5ms, 10ms, 20ms, 40ms, 80ms, 160ms, and so on. There are several cases of the specific transmission position of the SSB symbol within each period, and a specific case to which the transmission position belongs may be determined according to band information and subcarrier spacing (SCS) of the cell configuration.

In the operation of determining the transmission position case of the SSB symbol within the cycle period, the case may include SSB time domain cases in which the SCS is respectively 15kHz, 30kHz, 60kHz, 120kHz and 240kHz.

Case A 15kHz SCS: a transmission position of the first symbol of the SSB may be $\{2,8\} + 14 \cdot n$, where n = 0,1 when a carrier frequency is less than or equal to 3GHz, and n = 0,1, 2, 3 when the carrier frequency is greater than 3GHz and less than or equal to 6GHz.

Case B 30kHz SCS: the transmission position of the first symbol of the SSB may be $\{4,8,16,20\} + 28 \cdot n$, where n = 0 when the carrier frequency is less than or equal to 3GHz, and n = 0, 1 when the carrier frequency is greater than 3GHz and less than or equal to 6GHz.

Case C 60kHz SCS: the transmission position of the first symbol of the SSB may be {2,8} + 14·$n$, where, for a paired spectrum, n = 0,1 when the carrier frequency is less than or equal to 3GHz and n = 0,1, 2, 3 when the carrier frequency is greater than 3GHz and less than or equal to 6GHza, and, for an unpaired spectrum, n = 0,1 when the carrier frequency is less than or equal to 2.4GHz and n = 0, 1, 2, 3 when the carrier frequency is greater than 2.4GHz and less than or equal to 6GHz.

Case D 120kHz SCS: the transmission position of the first symbol of the SSB may be {4,8,16,20} + 28·$n$ , where n = 0,1,2,3,5,6,7,8,10,11,12,13,15,16,17,18 when the carrier frequency is greater than 6GHz.

Case E 240kHz SCS: the transmission position of the first symbol of the SSB may be {8,12,16,20,32,36,40,44} + 56·$n$, where n = 0,1,2,3,5,6,7,8 when the carrier frequency is greater than 6GHz.

It can be seen that there are a plurality of possible time domain positions of the SSB within one period in different cases, and the time domain position may be finally determined according to a specific position parameter of the SSB within one period. For example, in the Case B, when the carrier frequency is less than or equal to 3GHz, n = 0, so there are four possible transmission positions of the first symbol of the SSB, i.e. {4, 8, 16, 20}, and which one of the four transmission positions is the time domain position of the SSB may be finally determined according to the specific position parameter.

The operation of calculating the corresponding standing wave ratio based on the feedback signal and the reflected signal corresponding to the SSB symbol (i.e., the operation S103) may include: converting the feedback signal and the reflected signal corresponding to the SSB symbol into a frequency domain to find the corresponding SSB symbol and calculating the corresponding standing wave ratio. That is, when calculating the standing wave ratio, the corresponding SSB symbol in the frequency domain needs to be found for the calculation.

Before converting into the frequency domain to find the corresponding SSB symbol, the method may further include: determining a frequency domain position of the SSB symbol according to the cell configuration information. The timing when the frequency domain position of the SSB symbol is determined according to the cell configuration information just needs to be before the calculation of the standing wave ratio. In general, the frequency domain position of the SSB symbol may be determined as the operation S101, that is, determining the time domain position of the SSB symbol according to the cell configuration information, is performed.

The operation of determining the frequency domain position of the SSB symbol according to the cell configuration information may include: determining a central frequency point $SS_{REF}$ of the SSB symbol; determining a central frequency point $F_{REF}$ of a 5G NR carrier; and determining the frequency domain position of the SSB symbol based on the central frequency point $SS_{REF}$ of the SSB symbol and the central frequency point $F_{REF}$ of the 5G NR carrier.

Determining the central frequency point $SS_{REF}$ of the SSB symbol may include: determining the central frequency point $SS_{REF}$ of the SSB symbol according to the GSCN. The frequency domain position of the SSB symbol may be determined according to the GSCN, and each GSCN corresponds to one $SS_{REF}$, which is a frequency domain position of RE0 of RB10 of the SSB symbol, please see Table 1:

Table 1

| Frequency range | SSB frequency domain position | GSCN | Range of GSCN |
|---|---|---|---|
| 0-3000MHz | N ∗ 1200kHz + M ∗ 50kHz, N = 1: 2499, M∈{1,3,5} (Note 1) | 3N+(M-3)/2 | 2-7498 |
| 3000-24250MHz | 3000MHz + N ∗ 1.44MHz N=0:14756 | 7499+N | 7499-22255 |
| Note 1: a default value for operating bands with SCS spaced channel raster is M=3. | | | |

A method of calculating N and M in the above table is as follows:

below 3GHz: N= dividing the GSCN by 3 and rounding, M=(GSCN-3*N)*2+3; above 3GHz: N=GSCN-7499; after M and N are calculated according to the GSCN, the central frequency point $SS_{REF}$ of the SSB symbol may be calculated.

Determining the central frequency point $F_{REF}$ of the 5G NR carrier may include: determining the central frequency point $F_{REF}$ of the 5G NR carrier according to the ARFCN. The ARFCN is configured to indicate the central frequency point $F_{REF}$ of the 5G NR carrier, and a relation between the ARFCN and the central frequency point $F_{REF}$ of the 5G NR carrier is shown in the following formula: $F_{REF} = F_{REF-Offs} + \Delta F_{Global}(N_{REF} - N_{REF-Offs})$; and relevant parameters are shown in Table 2 as follows:

Table 2

| Frequency range (MHz) | $\Delta F_{Global}$ (kHz) | $F_{REF\text{-}Offs}$ (MHz) | $N_{REF\text{-}Offs}$ | Range of $N_{REF}$ |
|---|---|---|---|---|
| 0-3000 | 5 | 0 | 0 | 0-599999 |
| 3000-24250 | 15 | 3000 | 600000 | 600000-2016666 |

According to the standing wave ratio calculation method provided by the present disclosure, accurate acquisition of the feedback signal and the reflected signal corresponding to the SSB symbol can be realized by determining the time domain position of the SSB symbol, which makes it possible to accurately calculate the corresponding standing wave ratio, thereby realizing the calculation of the standing wave ratio of the 5G NR signals.

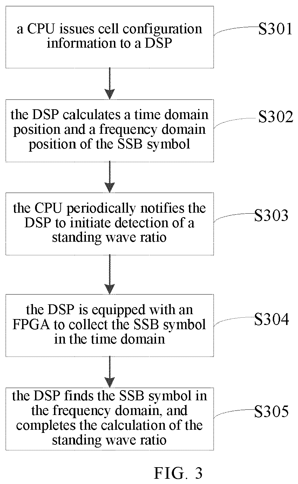

FIG. 3 is a detailed flowchart illustrating the standing wave ratio calculation method according to the present disclosure.

With reference to FIG. 3, the method includes operations S301 to S305.

In operation S301, a cell is built, and a Central Processing Unit (CPU) issues 5G NR-related cell configuration information to a Digital Signal Processor (DSP), with the cell configuration information including the ARFCN, the GSCN, the SSB time domain transmission period, the specific position of an SSB within one period, etc.

In operation S302, the DSP calculates a time domain position and a frequency domain position of a 5G NR SSB symbol according to the cell configuration information issued by the CPU.

The SSB symbol is transmitted periodically, the cycle period may be determined according to the SSB time-domain transmission period parameter, and currently, configurable cycle periods include 5ms, 10ms, 20ms, 40ms, 80ms and 160ms.

A specific transmission position of the SSB has five cases, i.e., the Cases A, B, C, D, E, within each period, and a specific case to which the transmission position belongs may be determined according to the band information and the subcarrier spacing of the cell configuration.

There are n possible time domain positions of the SSB within one period in different cases, and the time domain position may be finally determined according to the specific position parameter of the SSB within one period.

The central frequency point $SS_{REF}$ of the SSB symbol is calculated. According to section 5.4.3.1 of the Protocol 38101-1-f40, the frequency domain position of the SSB symbol may be determined according to the GSCN, and each GSCN corresponds to one $SS_{REF}$, which is the frequency domain position of RE0 of RB10 of the SSB symbol.

The central frequency point $F_{REF}$ of the 5G NR carrier is calculated. According to section 5.4.2.1 of the Protocol 38101-1-f40, the ARFCN is configured to indicate the central frequency point $F_{REF}$ of the 5G NR carrier.

$F_{REF}$ and $SS_{REF}$ may be calculated after the ARFCN and the GSCN are obtained, and then a position of the SSB relative to a center of the carrier may be obtained, so that the SSB symbol may be found in the frequency domain.

In operation S303, the CPU periodically notifies the DSP to initiate detection of a standing wave ratio.

In operation S304, the DSP is equipped with a Field Programmable Gate Array (FPGA) to collect the 5G NR SSB symbol in the time domain. The maximum transmission period of the SSB is 160ms, NR wireless frames have a length of 10ms and are numbered from 0, and the FPGA generates a sampling frame header from the frame 0 and then generates a sampling frame header every 16 wireless frames. The DSP calculates a specific position of the SSB symbol within one SSB transmission period, calculates a point number of the specific position of the SSB symbol relative to the sampling frame header by taking the 160ms sampling frame header as a start point, and configures the point number for the FPGA, so that the FPGA accurately collects the SSB symbol.

In operation S305, the DSP converts the feedback signal and the reflected signal corresponding to the SSB symbol collected in the time-division manner into the frequency domain to find the SSB symbol, completes the calculation of the standing wave ratio, and sends the standing wave ratio back to the CPU.

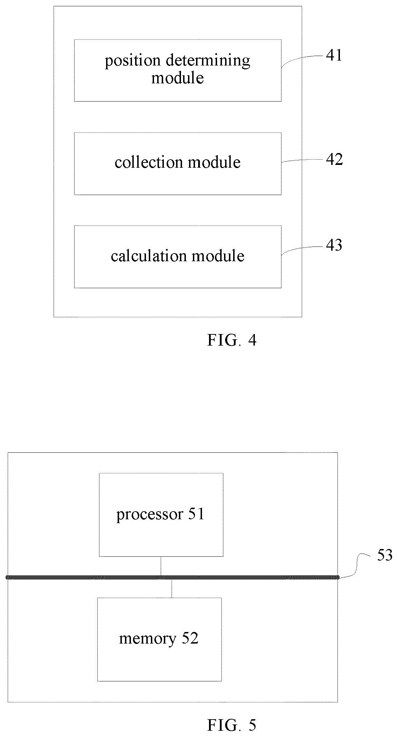

FIG. 4 is a schematic structural diagram of a standing wave ratio calculation apparatus according to the present disclosure.

With reference to FIG. 4, the standing wave ratio calculation apparatus provided by the present disclosure includes: a position determining module 41, a collection module 42 and a calculation module 43.

The position determining module 41 is configured to determine a time domain position of an SSB symbol according to cell configuration information. The collection module 42 is configured to collect a feedback signal and a reflected signal, which correspond to the SSB symbol, based on the time domain position. The calculation module 43 is configured to calculate a corresponding standing wave ratio based on the feedback signal and the reflected signal corresponding to the SSB symbol.

The time domain position of the SSB symbol may be determined according to the cell configuration information. The cell configuration information may include, but is not limited to, an ARFCN, a GSCN, an SSB time-domain transmission period, and a specific position of an SSB within one period. To determine the time domain position of the SSB symbol according to the cell configuration information may include: determining a cycle period of the SSB symbol; determining a transmission position case (CASE) of the SSB symbol within the cycle period; and determining the time domain position of the SSB symbol according to the transmission position case.

The SSB symbol is transmitted periodically, the cycle period may be determined according to an SSB time-domain transmission period parameter, and currently, configurable cycle periods include 5ms, 10ms, 20ms, 40ms, 80ms, 160ms, and so on. There are several cases of the specific transmission position of the SSB symbol within each period, and a specific case to which the transmission position belongs may be determined according to band information and subcarrier spacing (SCS) of the cell configuration.

When the transmission position case of the SSB symbol within the cycle period is determined, the case may include SSB time domain cases in which the SCS is respectively 15kHz, 30kHz, 60kHz, 120kHz and 240kHz.

To calculate the corresponding standing wave ratio based on the feedback signal and the reflected signal corresponding to the SSB symbol may include: converting the feedback signal and the reflected signal corresponding to the SSB symbol into a frequency domain to find the corresponding SSB symbol and calculating the corresponding standing wave ratio. That is, when calculating the standing wave ratio, the corresponding SSB symbol in the frequency domain needs to be found for the calculation.

Before converting into the frequency domain to find the corresponding SSB symbol, the following operation may be further performed: determining a frequency domain position of the SSB symbol according to the cell configuration information. The timing when the frequency domain position of the SSB symbol is determined according to the cell configuration information just needs to be before the calculation of the standing wave ratio. In general, the frequency domain position of the SSB symbol may be determined while the time domain position of the SSB symbol is determined according to the cell configuration information.

Determining the frequency domain position of the SSB symbol according to the cell configuration information may include: determining a central frequency point $SS_{REF}$ of the SSB symbol; determining a central frequency point $F_{REF}$ of a 5G NR carrier; and determining the frequency domain position of the SSB symbol based on the central frequency point $SS_{REF}$ of the SSB symbol and the central frequency point $F_{REF}$ of the 5G NR carrier.

Determining the central frequency point $SS_{REF}$ of the SSB symbol may include: determining the central frequency point $SS_{REF}$ of the SSB symbol according to the GSCN.

Determining the central frequency point $F_{REF}$ of the 5G NR carrier may include: determining the central frequency point $F_{REF}$ of the 5G NR carrier according to the ARFCN.

According to the standing wave ratio calculation apparatus provided by the present disclosure, accurate acquisition of the feedback signal and the reflected signal corresponding to the SSB symbol can be realized by determining the time domain position of the SSB symbol, which makes it possible to accurately calculate the corresponding standing wave ratio, thereby realizing the calculation of the standing wave ratio of the 5G NR signals.

FIG. 5 is a schematic structural diagram of a network device according to the present disclosure.

With reference to FIG. 5, the network device provided by the present disclosure includes a processor 51, a memory 52 and a communication bus 53.

The communication bus 53 is configured to enable connection and communication between the processor 51 and the memory 52.

The processor 51 is configured to execute one or more computer programs stored in the memory 52 so as to perform the standing wave ratio calculation method according to the present disclosure, which will not be described in detail here.

The present disclosure further provides a computer-readable storage medium, including volatile/nonvolatile and removable/non-removable media used in any method or technology for storing information (such as computer-readable instructions, data structures, computer program modules or other data). The computer-readable storage medium includes, but is not limited to, a Random Access Memory (RAM), a Read-Only Memory (ROM), an Electrically Erasable Programmable Read-Only Memory (EEPROM), a flash memory or other memories, a Compact Disc Read-Only Memory (CD-ROM), a Digital Video Disk (DVD) or other optical discs, a magnetic cassette, a magnetic tape, a magnetic disk or other magnetic storage devices, or any other medium which can be used to store the desired information and can be accessed by a computer.

The computer-readable storage medium herein may be configured to store one or more computer programs, which are executable by one or more processors to perform the standing wave ratio calculation method according to the present disclosure.

The present disclosure further provides a computer program (also called computer software), which may be distributed on a computer readable medium and executed by a computing device to perform the standing wave ratio calculation method according to the present disclosure; and in some cases, at least one of the operations illustrated or described may be performed in an order different from that described above.

The present disclosure further provides a computer program product, including a computer program. When the computer program is executed by a processor, the standing wave ratio calculation method according to the present disclosure is carried out.

According to the standing wave ratio calculation method and apparatus, the network device and the storage medium, the time domain position of the SSB symbol can be determined according to the cell configuration information; the feedback signal and the reflected signal corresponding to the SSB symbol can be collected based on the time domain position; and the corresponding standing wave ratio can be calculated based on the feedback signal and the reflected signal corresponding to the SSB symbol. Thus, it can be ensured that the feedback signal and the reflected signal corresponding to the SSB symbol can be accurately acquired by determining the time domain position of the SSB symbol even in the presence of the characteristics of the signals of the 5G physical layer, so that the problems that a wrong signal is acquired and no signal can be acquired can be avoided, which makes it possible to accurately calculate the corresponding standing wave ratio, thereby realizing the calculation of the standing wave ratio of the 5G NR signals.

It should be understood by those of ordinary skill in the art that the functional modules/units in all or some of the operations, the systems and the devices in the method disclosed above may be implemented as software (which may be implemented as computer program codes executable by a computing device), firmware, hardware, or suitable combinations thereof. If implemented as hardware, the division between the functional modules/units described above is not necessarily corresponding to the division of physical components; for example, one physical component may have a plurality of functions, or one function or operation may be performed through cooperation of several physical components. Some or all of the physical components may be implemented as software executed by a processor, such as a CPU, a DSP or a microprocessor, or may be implemented as hardware, or may be implemented as an integrated circuit, such as an application specific integrated circuit.

In addition, it is well known by those of ordinary skill in the art that communication media generally include computer-readable instructions, data structures, computer program modules or other data in a modulated data signal, such as a carrier wave or other transmission mechanism, and may include any information delivery medium. Therefore, the present disclosure is not limited to any specific combination of hardware and software.

The above is a further detailed description of the embodiments of the present disclosure in conjunction with the specific implementations, but the specific implementations of the present disclosure are not limited to the above description. Several simple deductions or substitutions can be made by those of ordinary skill in the art without departing from the concept of the present disclosure, and should be considered to fall within the scope of the present disclosure.

**Claims**

1. A standing wave ratio calculation method, comprising:

   determining a time domain position of a synchronization/broadcast block, called SSB, symbol according to cell configuration information;
   collecting a feedback signal and a reflected signal, which correspond to the SSB symbol, based on the time domain position; and
   calculating a corresponding standing wave ratio based on the feedback signal and the reflected signal corresponding to the SSB symbol.

2. The standing wave ratio calculation method of claim 1, wherein determining the time domain position of the SSB symbol according to the cell configuration information comprises:

   determining a cycle period of the SSB symbol;
   determining a transmission position case of the SSB symbol within the cycle period; and
   determining the time domain position of the SSB symbol according to the transmission position case.

3. The standing wave ratio calculation method of claim 2, wherein in the operation of determining the transmission position case of the SSB symbol within the cycle period, the case comprises SSB time domain cases in which subcarrier spacing is respectively 15kHz, 30kHz, 60kHz, 120kHz and 240kHz.

4. The standing wave ratio calculation method of any one of claims 1 to 3, wherein calculating the corresponding standing wave ratio based on the feedback signal and the reflected signal corresponding to the SSB symbol comprises:
   converting the feedback signal and the reflected signal corresponding to the SSB symbol into a frequency domain to find the corresponding SSB symbol, and calculating the corresponding standing wave ratio.

5. The standing wave ratio calculation method of claim 4, wherein before converting into the frequency domain to find the corresponding SSB symbol, the method further comprises:
determining a frequency domain position of the SSB symbol according to the cell configuration information.

6. The standing wave ratio calculation method of claim 5, wherein determining the frequency domain position of the SSB symbol according to the cell configuration information comprises:

   determining a central frequency point of the SSB symbol;
   determining a central frequency point of a 5G New Radio, called NR, carrier; and
   determining the frequency domain position of the SSB symbol based on the central frequency point of the SSB symbol and the central frequency point of the 5G NR carrier.

7. The standing wave ratio calculation method of claim 6, wherein determining the central frequency point of the SSB symbol comprises:
determining the central frequency point of the SSB symbol according to a Global Synchronization Channel Number.

8. The standing wave ratio calculation method of claim 6, wherein determining the central frequency point of the 5G NR carrier comprises:
determining the central frequency point of the 5G NR carrier according to an Absolute Radio Frequency Channel Number.

9. A standing wave ratio calculation apparatus, comprising:

   a position determining module configured to determine a time domain position of an SSB symbol according to cell configuration information;
   a collection module configured to collect a feedback signal and a reflected signal, which correspond to the SSB symbol, based on the time domain position; and
   a calculation module configured to calculate a corresponding standing wave ratio based on the feedback signal and the reflected signal corresponding to the SSB symbol.

10. A network device, comprising a processor and a memory;
wherein the processor is configured to execute one or more computer programs stored in the memory, so as to perform the standing wave ratio calculation method of any one of claims 1 to 8.

11. A computer-readable storage medium having one or more computer programs stored thereon, wherein when the one or more computer programs are executed by one or more processors, the one or more processors are caused to perform the standing wave ratio calculation method of any one of claims 1 to 8.

determine a time domain position
of an SSB symbol according to
cell configuration information — S101

↓

collect a feedback signal and a
reflected signal — S102

↓

calculate a corresponding
standing wave ratio — S103

FIG. 1

239

PBCH

192

182

PSS | PBCH | SSS | PBCH

subcarrier
number

56

47

PBCH

0

0    1    2    3

OFDM symbol number

FIG. 2

a CPU issues cell configuration information to a DSP —— S301

the DSP calculates a time domain position and a frequency domain position of the SSB symbol —— S302

the CPU periodically notifies the DSP to initiate detection of a standing wave ratio —— S303

the DSP is equipped with an FPGA to collect the SSB symbol in the time domain —— S304

the DSP finds the SSB symbol in the frequency domain, and completes the calculation of the standing wave ratio —— S305

FIG. 3

position determining module — 41

collection module — 42

calculation module — 43

FIG. 4

processor 51

— 53

memory 52

FIG. 5

## INTERNATIONAL SEARCH REPORT

International application No.

**PCT/CN2021/101469**

| A. | CLASSIFICATION OF SUBJECT MATTER |
|---|---|

H04B 17/10(2015.01)i

According to International Patent Classification (IPC) or to both national classification and IPC

| B. | FIELDS SEARCHED |
|---|---|

Minimum documentation searched (classification system followed by classification symbols)

H04B; H04L; H04W

Documentation searched other than minimum documentation to the extent that such documents are included in the fields searched

Electronic data base consulted during the international search (name of data base and, where practicable, search terms used)

CNABS; CNTXT; CNKI; VEN; WOTXT; EPTXT; USTXT; 3GPP: 驻波比, SWR, 同步信号, SSB, 主同步, 辅同步, SSS, PSS, 时域位置, 频域位置, standing wave ratio, synchronization signal, time domain position, frequency domain position, 5G, 5th generation

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 107809291 A (WUHAN RESEARCH INSTITUTE OF POST AND TELECOMMUNICATION) 16 March 2018 (2018-03-16) description paragraphs 34, 43-91 | 1, 4-11 |
| Y | CN 107809291 A (WUHAN RESEARCH INSTITUTE OF POST AND TELECOMMUNICATION) 16 March 2018 (2018-03-16) description paragraphs 34, 43-91 | 2, 3 |
| Y | CN 110574447 A (LG ELECTRONICS INC.) 13 December 2019 (2019-12-13) description paragraphs 102-213 | 2, 3 |
| A | CN 110892657 A (ZTE CORPORATION) 17 March 2020 (2020-03-17) entire document | 1-11 |
| A | US 2016365965 A1 (FUJITSU LIMITED) 15 December 2016 (2016-12-15) entire document | 1-11 |
| A | US 2017026137 A1 (TELEFONAKTIEBOLAGET LM ERICSSON (PUBL)) 26 January 2017 (2017-01-26) entire document | 1-11 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **03 September 2021** | **15 September 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/101469**

| Patent document cited in search report | | | Publication date (day/month/year) | Patent family member(s) | | | Publication date (day/month/year) |
|---|---|---|---|---|---|---|---|
| CN | 107809291 | A | 16 March 2018 | None | | | |
| CN | 110574447 | A | 13 December 2019 | US | 2019215790 | A1 | 11 July 2019 |
| | | | | JP | 6728470 | B2 | 22 July 2020 |
| | | | | US | 2020351805 | A1 | 05 November 2020 |
| | | | | US | 10470144 | B2 | 05 November 2019 |
| | | | | RU | 2731360 | C1 | 02 September 2020 |
| | | | | PH | 12019500078 | A1 | 29 July 2019 |
| | | | | CA | 3029821 | A1 | 20 December 2018 |
| | | | | JP | 2019525596 | A | 05 September 2019 |
| | | | | AU | 2018283571 | A1 | 24 January 2019 |
| | | | | SG | 11201900100 W | A | 27 February 2019 |
| | | | | WO | 2018230879 | A1 | 20 December 2018 |
| | | | | US | 2020053671 | A1 | 13 February 2020 |
| | | | | BR | 112019000576 | A2 | 21 January 2020 |
| | | | | US | 10638437 | B2 | 28 April 2020 |
| | | | | US | 10750461 | B2 | 18 August 2020 |
| | | | | CL | 2019000094 | A1 | 12 April 2019 |
| | | | | EP | 3641417 | A1 | 22 April 2020 |
| | | | | US | 2020029287 | A1 | 23 January 2020 |
| | | | | US | 2020145943 | A1 | 07 May 2020 |
| | | | | KR | 102138535 | B1 | 28 July 2020 |
| | | | | KR | 101915997 | B1 | 07 November 2018 |
| | | | | EP | 3641417 | A4 | 17 February 2021 |
| | | | | KR | 20180136917 | A | 26 December 2018 |
| | | | | AU | 2018283571 | B2 | 09 July 2020 |
| | | | | MX | 2019000573 | A | 04 July 2019 |
| | | | | US | 10687292 | B2 | 16 June 2020 |
| CN | 110892657 | A | 17 March 2020 | JP | 2020529795 | A | 08 October 2020 |
| | | | | US | 10892870 | B2 | 12 January 2021 |
| | | | | RU | 2735670 | C1 | 05 November 2020 |
| | | | | EP | 3665796 | A4 | 07 October 2020 |
| | | | | US | 2020162217 | A1 | 21 May 2020 |
| | | | | WO | 2019028755 | A1 | 14 February 2019 |
| | | | | KR | 20200033964 | A | 30 March 2020 |
| | | | | US | 2021058208 | A1 | 25 February 2021 |
| | | | | EP | 3665796 | A1 | 17 June 2020 |
| US | 2016365965 | A1 | 15 December 2016 | JP | 2017005514 | A | 05 January 2017 |
| US | 2017026137 | A1 | 26 January 2017 | EP | 2828991 | B1 | 26 April 2017 |
| | | | | US | 2013245976 | A1 | 19 September 2013 |
| | | | | US | 9482705 | B2 | 01 November 2016 |
| | | | | WO | 2013140275 | A1 | 26 September 2013 |
| | | | | US | 10291333 | B2 | 14 May 2019 |
| | | | | EP | 2828991 | A1 | 28 January 2015 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010575962